Europäisches Patentamt

European Patent Office

Office européen des brevets

(19)

(11) Numéro de publication: **0 415 316 B1**

(12) **FASCICULE DE BREVET EUROPEEN**

(45) Date de publication de fascicule du brevet: **29.06.94**  (51) Int. Cl.5: **H03L 7/087**

(21) Numéro de dépôt: **90116377.4**

(22) Date de dépôt: **27.08.90**

(54) **Dispositif de récupération de porteuse à boucle de costas.**

(30) Priorité: **29.08.89 FR 8911334**

(43) Date de publication de la demande:
**06.03.91 Bulletin  91/10**

(45) Mention de la délivrance du brevet:
**29.06.94 Bulletin  94/26**

(84) Etats contractants désignés:
**DE ES FR GB IT SE**

(56) Documents cités:
**EP-A- 0 155 396
GB-A- 2 007 445
GB-A- 2 099 245
US-A- 4 072 909
US-A- 4 336 616**

**IEEE TRANSACTIONS ON CONSUMER ELEC-
TRONICS, vol. CE-23, no. 3, août 1977, pages
358-365, New York, US; R. CITTA: "Frequency
and phase lock loop"**

(73) Titulaire: **ALCATEL ESPACE
11, avenue Dubonnet
F-92407 Courbevoie Cédex(FR)**
(84) Etats contractants désignés:
**DE ES FR GB IT**

(73) Titulaire: **ALCATEL N.V.
Strawinskylaan 341,
(World Trade Center)
NL-1077 XX Amsterdam(NL)**
(84) Etats contractants désignés:
**SE**

(72) Inventeur: **Rousselet, Dominique
47 Chemin de Rivalsupervic
Bât. C-App 16, F-31400 Toulouse(FR)**
Inventeur: **Michau, Patrick
11, Route de Saint Simon
F-31100 Toulouse(FR)**
Inventeur: **Foucher, Jean-Luc
120 Chemin de la Longue
F-31600 Seysses(FR)**
Inventeur: **Triaud, Pascal
8, rue de l'Isère
F-31170 Tournefeuille(FR)**

(74) Mandataire: **Weinmiller, Jürgen et al
Lennéstrasse 9
Postfach 24
D-82336 Feldafing (DE)**

## Description

L'invention concerne un dispositif de récupération de porteuse à boucle de Costas.

Un tel dispositif est utilisable notamment, en spatial, dans un transpondeur bande S à étalement de spectre pour la mise à poste et le maintien à poste de satellites.

Un document de la NASA STDN N° 203.8 intitulé "Performance and design requirements specification for the second generation TDRSS user transponder" d'Avril 1986 définit l'utilisation d'un tel transpondeur dont le temps d'acquisition de porteuse doit notamment être inférieur à 5 secondes avec une probabilité de 90%.

Le rôle d'une boucle de Costas dans un récepteur à étalement de spectre est de permettre une démodulation cohérente des données et, dans le cas d'une boucle longue, d'offrir la possibilité d'avoir un émetteur cohérent avec le récepteur.

Une telle boucle doit inclure un indicateur d'accrochage et permettre la fonction de contrôle automatique de gain dans le récepteur. La fonction globale à réaliser est dépendante de contraintes liées aux spécifications du signal d'entrée du récepteur :
- Fréquence d'entrée (pente de la variation et écart maximum) ;
- Rapport signal à densité de bruit minimum :
- Rythme de bits ;
- Pertes de démodulation ;
- Temps d'accrochage de la boucle.

Il est connu de l'art antérieur, notamment par le document US-A-4 336 616, un dispositif à boucle de Costas, ayant deux boucles I et Q dissymétriques, dans lequel la largeur de bande commandable d'un filtre passe-bas sur la voie Q est environ dix fois plus élevée que celle d'un deuxième filtre passe-bas sur la voie I lors de l'acquisition de la porteuse, donnant lieu à un effet de discriminateur de fréquence. Ensuite la largeur de bande de la voie Q est commutée pour être substantiellement identique à celle de la voie I pour suivre au mieux les évolutions éventuelles de la fréquence de la porteuse, à condition que ces évolutions ne soient trop rapides. Cette construction permet d'améliorer le temps d'acquisition de la boucle, mais la poursuite en fréquence reste médiocre pour des faibles rapports de signal sur bruit.

Il est également connu, notamment par le document GB-A-2 007 445, une boucle de Costas comportant, dans la voie I, un filtre passe-bas dont la caractéristique de transfert est sélectionnée par commutation entre deux branches à l'intérieur du filtre de bras. Dans ce filtre de bras, une branche est directe et une autre branche comporte un amplificateur de gain -$\alpha$ et un différentiateur en séries. Le commutateur est commandé par la polarité de la voie Q de la boucle.

Dans ces deux documents de l'art antérieur, le but recherché est de permettre l'acquisition rapide de la porteuse avec une bande relativement large de boucle lors de la phase d'acquisition, et ensuite après verrouillage, et par commutation sur une autre caractéristique de filtre, de continuer la poursuite de fréquence de la porteuse dans une boucle ayant une bande relativement étroite. Les deux documents enseignent des solutions similaires, et préconisent l'utilisation de filtres de bras dissymétriques lors de la phase d'acquisition de porteuse, permettant une acquisition plus rapide. En revanche, la poursuite en fréquence nécessaire pour suivre la variation par effet Doppler, une fois la boucle verrouillée, conditionne le rapport minimal de signal sur bruit qui peut être toléré sans décrocher le démodulateur.

Ces contraintes sont contradictoires et ont obligé, jusqu'à présent, les constructeurs à définir des plages d'utilisation en fonction du rapport signal a densité de bruit à l'entrée.

L'invention a pour objet de résoudre ces différents problèmes.

L'invention propose à cet effet un dispositif de récupération de porteuse à boucle de Costas, ladite porteuse étant caractérisée par une phase et une fréquence dites de porteuse ; ladite boucle de Costas comprenant en outre un premier et un second bras dite en phase et en quadrature, respectivement ; chaque bras comprenant notamment un filtre passebande dit filtre de bras ; ladite boucle de Costas comprenant en outre un oscillateur commandé en tension, lesdits bras étant reliés tous deux audit oscillateur par l'intermédiaire d'un filtre passebande commun dit filtre de boucle ; caractérisé en ce que :

ledit filtre de boucle est relié à l'entrée de commande dudit oscillateur via deux voies disposées en parallèle :
- une première voie dite directe, reliant ledit filtre de boucle directement audit oscillateur ;
- et une deuxième voie dite parallèle, comportant un amplificateur et un filtre passe-bas connectés en séries, le filtre passe-bas ayant une fréquence de coupure ;

et en ce que :

ladite fréquence de coupure dudit filtre passebas est inférieure à $w_n/5$, $w_n$ étant la pulsation propre de ladite boucle de Costas.

L'invention permet de supprimer les plages d'utilisation définies précédemment et d'améliorer le service rendu en tenant compte de toutes les spécifications à la fois. D'autre part grâce à celle-ci les stations sol de poursuite de satellites peuvent être simplifiées.

L'invention permet, de plus :

- de réaliser une fonction discriminateur de fréquence de façon à acquérir le signal rapidement, ceci même avec une bande de boucle étroite :
- de réaliser un diviseur d'erreur de phase statique dans la bande de boucle pour pouvoir poursuivre les rampes de Doppler sans compensation avec une boucle étroite et aider à une acquisition rapide.

Les caractéristiques et avantages de l'invention ressortiront de la description qui va suivre, à titre d'exemple non limitatif, en référence aux dessins annexés sur lesquels :

- la figure 1 illustre un dispositif de l'art antérieur :
- la figure 2 illustre le dispositif de l'invention.

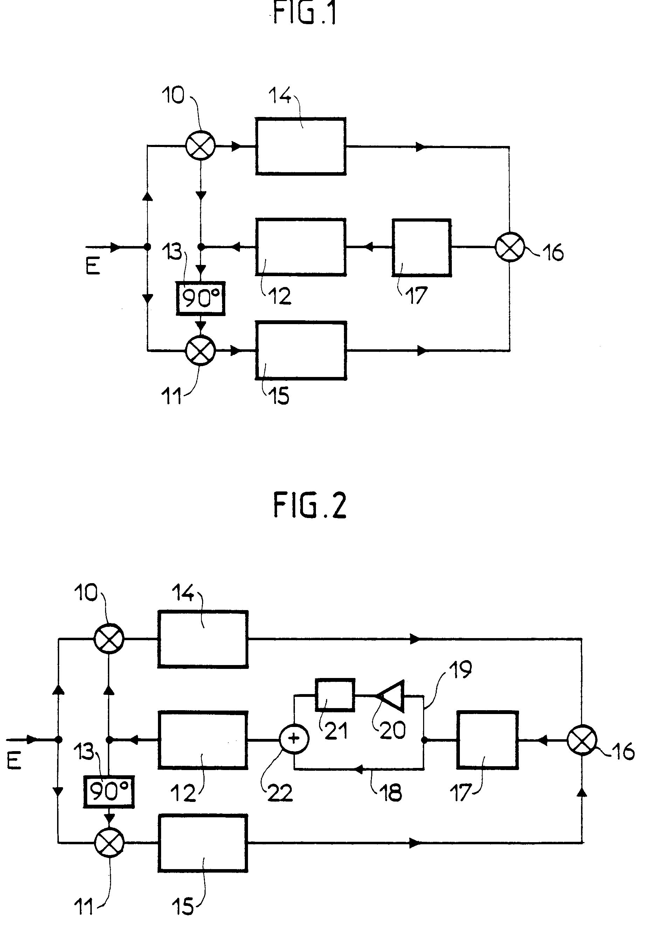

Le synoptique représenté à la figure 1 est celui d'un dispositif de l'art connu.

Dans une démodulation cohérente de signaux modulés linéairement se pose le problème de récupération de la porteuse. Une bouche de Costas est une structure bouclée qui permet d'obtenir l' estimation de phase de la porteuse : La bande passante du filtre de bouche qui détermine la durée de la réponse impulsionnelle peut être choisie d'autant plus étroite que la phase de la porteuse émise est stable.

Une telle bouche comporte deux modulateurs en anneau 10 et 11 reliés en entrées d'une part au signal d'entrée E et à la sortie d'un oscillateur commandé en tension 12, via un déphaseur de 90° 13 pour l'un d'eux. Les sorties de ces deux modulateurs sont reliées respectivement à deux filtres 14 et 15 dont les sorties sont reliées à un troisième modulateur en anneau 16. Un filtre 17 dit "filtre de bouche" est interposé entre ce modulateur et l'oscillateur commandé en tension.

L'oscillateur contrôlé en tension 12 suit la porteuse du signal d'entrée (E). Les filtres 14 et 15, dits "filtres de bras", ont une fréquence de coupure sensiblement égale au rythme de bits.

Le filtre 17 définit la bande bouche et donc les plages de fonctionnement.

Une telle solution fait appel à une bouche de Costas du second ordre dont on commute la bande de bouche en fonction de la qualité du signal d'entrée.

Lorsque le rapport signal à densité de bruit (S/No) augmente à l'entrée du récepteur, on augmente la bande de bouche (Δf) de façon à pouvoir poursuivre des rampes de fréquence plus élevées sans faire décrocher le récepteur et en diminuant les pertes de démodulation.

Inversement, si le rapport signal à densité de bruit (S/No) diminue, on diminue la bande de boucle (Δf) du récepteur de façon à ne pas décrocher sur des "pics" de bruit. Dans ce cas, il faut veiller à limiter les variations de fréquence en entrée sinon le récepteur aura de fortes pertes et finira par décrocher. De même, sur une bouche conventionnelle, la diminution de cette bande de bouche ralentit le phénomène d'acquisition de la boucle.

Les performances des systèmes de l'art connu sont les suivantes :

- pour un $\frac{S}{No} \geq 33$ dBHz, $\Delta f/\Delta T \leq 70$ Hz/sec (donc le doppler doit être compensé au sol) ;
- pour un $\frac{S}{No} \geq 40$ dBHz, $\Delta f/\Delta T \leq 380$ Hz/sec (il n'y a plus de compensation nécessaire).

Le temps d'accrochage est inférieur à 5 secondes pour un écart de 1400 Hz maximum.

Le dispositif de l'invention est représenté à la figure 2. Sur cette figure les circuits analogues à ceux représentés de la figure 1 ont conservé les mêmes références.

Le filtre de bouche 17 est à présent relié à l'oscillateur commandé en tension 12 au travers de deux voies :

- une voie directe 18 :
- et une voie parallèle 19 comportant un amplificateur 20 en série avec un filtre 21 ;

ces deux voies étant sommées grâce à un sommateur 22.

Un tel dispositif permet d'obtenir un seuil bas (33 dBHz) tout en se donnant la possibilité de suivre des rampes de Doppler élevées ( $\geq$ 380 Hz/sec) sans décrocher le récepteur et même en ayant de bonnes performances en termes de pertes. (Ces pertes sont liées aux erreurs de phases statiques élevées de la boucle étroite

$$\Delta \phi = \frac{\Delta w}{\frac{w^2}{w_n}})$$

De plus, même avec une boucle étroite, on peut s'accrocher rapidement pour améliorer le service rendu à l'utilisateur.

Le choix de la bande de boucle se fait en fonction du seuil minimum. Cette bande de boucle est inchangée par la suite.

Pour une acquisition rapide du signal, on dissymétrise les filtres de bras 14 et 15. Cette différence de temps de groupe entre les deux filtres crée un signal d'erreur proportionnel à l'écart initial de fréquence. Le temps d'acquisition est divisé par 10 (0.5 secondes au lieu de 5 secondes) : le filtre 15 du second bras étant choisi au moins 5 fois plus large que le filtre 14 du premier bras.

Pour pouvoir suivre des rampes de fréquence supérieures aux valeurs habituelles (il existe un rapport > 6) et acquérir le signal encore plus rapidement, on ajoute en sortie du filtre de boucle 17 un système parallèle filtre 21 + gain 20 dont le rôle est de diviser les erreurs de phase statiques, en ne rendant opérant le gain 20 que pour des fréquences très basses : Pour que la boucle fonctionne avec sa bande préalablement fixée et qu'elle soit stable, il est impératif que ce système soit inopérant au delà de $w_n/5$.

Un tel système crée une boucle du second ordre dont les performances sont proches de celles d'un troisième ordre, tout en restant simple à fabriquer.

Les performances sont les suivantes :
S/No $\geq$ 33 dBHz, $\Delta f/\Delta T \leq$ 500 Hz/sec.

L'accrochage pour une $\Delta f$ de 1400 Hz est réalisé en 0.5 seconde.

La pulsation propre de la boucle est $w_n$ = 100 rad/sec.

Avec un gain de 6 en tension on peut suivre avec une boucle étroite des rampes 6 fois plus élevées qu'avec le dispositif représenté à la figure 1. De plus, ce gain continue additionnel joue un rôle d'accélérateur pour l'acquisition en fréquence.

Ainsi le dispositif de l'invention permet avantageusement :

- un accrochage plus rapide (0.5 seconde au lieu de 5 secondes) de la boucle de poursuite de la porteuse, donc de la fonction de démodulation :
- une poursuite de la porteuse montante sans précompensation de l'effet Doppler au niveau des stations "sol", ceci même au seuil du récepteur (seuil pour la poursuite sans compensation inférieur de 6 dB à celui des dispositifs de l'art connu.

Il est bien entendu que la présente invention n'a été décrite et représentée qu'à titre d'exemple préférentiel et que l'on pourra remplacer ses éléments constitutifs par des éléments équivalents sans, pour autant, sortir du cadre de l'invention.

## Revendications

1. Dispositif de récupération de porteuse à boucle de Costas, ladite porteuse étant caractérisée par une phase et une fréquence dites de porteuse ; ladite boucle de Costas comprenant en outre un premier et un second bras dits en phase et en quadrature, respectivement ; chaque bras comprenant notamment un filtre passebande (14,15) dit filtre de bras ; ladite boucle de Costas comprenant en outre un oscillateur commandé en tension (12), lesdits bras étant reliés tous deux audit oscillateur (12) par l'intermédiaire d'un filtre passebande commun (17) dit filtre de boucle ; caractérisé en ce que :

ledit filtre de boucle (17) est relié à l'entrée de commande dudit oscillateur (12) via deux voies (18,19) disposées en parallèle :
- une première voie (18) dite directe, reliant ledit filtre de boucle (17) directement audit oscillateur (12) ;
- et une deuxième voie (19) dite parallèle, comportant un amplificateur (20) et un filtre passe-bas (21) connectés en séries, le filtre passe-bas (21) ayant une fréquence de coupure ;
et en ce que :
ladite fréquence de coupure dudit filtre passe-bas (21) est inférieure à $w_n/5$, $w_n$ étant la pulsation propre de ladite boucle de Costas.

2. Dispositif selon la revendication 1, caractérisé en ce que ledit deuxième filtre passebande (15) dudit second bras possède une bande passante au moins cinq fois plus large que celle dudit premier filtre passebande (14) dudit premier bras.

3. Dispositif selon la revendication 1, caractérisé en ce que l'amplificateur (20) de ladite voie parallèle (19) possède un gain en tension de 6.

## Claims

1. Costas loop carrier recovery device, said carrier being characterised by a carrier phase and a carrier frequency, said Costas loop further comprising first and second phase and quadrature arms, respectively; each arm includes a bandpass arm filter (14, 15); said Costas loop further comprising a voltage-control oscillator (12), both said arms being connected to said oscillator (12) by a common loop bandpass filter (17); characterised in that:

said loop filter (17) is connected to the control input of said oscillator (12) via two paths (18, 19) in parallel:
- a direct first path (18) connecting said loop filter (17) directly to said oscillator (12); and
- a parallel second channel (19) comprising an amplifier (20) and a low-pass filter (21) connected in series, the low-pass filter (21) having a cut-off frequency;
and in that:
said cut-off frequency of said low-pass filter (21) is less than $w_n/5$ where $w_n$ is the angular frequency of said Costas loop.

2. Device according to claim 1 characterised in that the bandwidth of said second arm bandpass filter (15) is at least five times wider than that of said first arm bandpass filter (14).

3. Device according to claim 1 characterised in that said amplifier (20) in said parallel circuit (19) has a voltage gain of 6.

**Patentansprüche**

1. Vorrichtung zur Trägerrückgewinnung mit Costas-Schleife, wobei der Träger durch eine Trägerfrequenz und eine Trägerphase gekennzeichnet ist und die Costas-Schleife außerdem einen ersten Zweig in Phase und einen zweiten Zweig in Quadratur, die je ein Bandpaßfilter (14, 15) enthalten, und weiter einen spannungsgesteuerten Oszillator (12) besitzt, wobei beide Zweige über ein gemeinsames Bandpaßfilter (17), Schleifenfilter genannt, mit dem Oszillator (12) verbunden sind, dadurch gekennzeichnet, daß das Schleifenfilter (17) an den Steuereingang des Oszillators (12) über zwei parallele Wege (18, 19) angeschlossen ist, und zwar

   - einen ersten Weg (18), direkter Weg genannt, der das Schleifenfilter (17) direkt mit dem Oszillator (12) verbindet,
   - und einen zweiten Weg (19), paralleler Weg genannt, der in Serie einen Verstärker (20) und ein Tiefpaßfilter (21) mit einer Grenzfrequenz enthält,

   und daß die Grenzfrequenz des Tiefpaßfilters (21) unterhalb von $w_n/5$ liegt, wobei $w_n$ die Eigenschwingung der Costas-Schleife ist.

2. Vorrichtung nach Anspruch 1, dadurch gekennzeichnet, daß das Bandpaßfilter (15) des zweiten Zweigs ein mindestens fünfmal breiteres Durchlaßband als das Bandpaßfilter (14) des ersten Zweigs besitzt.

3. Vorrichtung nach Anspruch 1, dadurch gekennzeichnet, daß der Verstärker (20) im parallelen Weg (19) einen Spannungsverstärkungsgrad von 6 besitzt.

# FIG.1

# FIG.2